# EUROPÄISCHE PATENTSCHRIFT

(11) **EP 2 768 999 B1**
(45) Veröffentlichungstag und Bekanntmachung des Hinweises auf die Patenterteilung: **28.12.2016**
(21) Anmeldenummer: 12783880.3
(22) Anmeldetag: 18.10.2012
(51) Int. Cl.: C23C 14/06, C23C 14/54, C23C 16/50, C23C 30/00, C23C 14/34, C23C 28/04, C23C 16/27, B23G 5/00, C23C 14/35, H01J 37/34

(54) **BOHRER MIT BESCHICHTUNG**
DRILL HAVING A COATING
FORET PRÉSENTANT UN REVÊTEMENT

(30) Priorität: 21.10.2011 DE 102011116576
(43) Veröffentlichungstag der Anmeldung: 27.08.2014
(73) Patentinhaber: Oerlikon Surface Solutions AG, Pfäffikon, 8808 Pfäffikon (CH)
(72) Erfinder: KRASSNITZER, Siegfried, A-6800 Feldkirch (AT)
(74) Vertreter: Kempkens, Anke
(86) Internationale Anmeldenummer: PCT/EP2012/004352
(87) Internationale Veröffentlichungsnummer: WO 2013/056831

(56) Entgegenhaltungen:
- EP-A2- 2 072 637
- WO-A1-2006/089753
- WO-A1-2012/143087
- WO-A1-2012/143110
- DE-A1-102008 021 912
- JP-A- 2011 189 419
- US-A1- 2008 292 812
- US-A1- 2011 220 415
- "Entwicklungen von HIPIMS und HIPIMS+ Technology", WERKZEUGTECHNIK, Bd. 115, 15. September 2010 (2010-09-15), Seiten 1-2, XP002693021,
- MUNZ W-D ET AL: "Industrial applications of HIPIMS", JOURNAL OF PHYSICS: CONFERENCE SERIES, INSTITUTE OF PHYSICS PUBLISHING, BRISTOL, GB, Bd. 100, Nr. Part. 8, 1. März 2008 (2008-03-01), Seiten 1-6, XP002565193, ISSN: 1742-6596, DOI: 10.1088/1742-6596/100/8/082001
- HOVSEPIAN P EH ET AL: "Novel TiAlCN/VCN nanoscale multilayer PVD coatings deposited by the combined high-power impulse magnetron sputtering/unbalanced magnetron sputtering (HIPIMS/UBM) technology", VACUUM, PERGAMON PRESS, GB, Bd. 82, Nr. 11, 19. Juni 2008 (2008-06-19) , Seiten 1312-1317, XP022733461, ISSN: 0042-207X, DOI: 10.1016/J.VACUUM.2008.03.064 [gefunden am 2008-04-08]

## Beschreibung

Die Erfindung bezieht sich auf einen Bohrer nach dem Oberbegriff des Patentanspruchs 1, insbesondere auf einen Gewindebohrer oder einen Mikrobohrer, sowie auch auf ein Beschichtungsverfahren nach dem Oberbegriff des Patentanspruchs 9 für die Beschichtung von Bohrern. Gewindebohrer weisen zumeist einen Anschnitt und einen sich an diesen anschließenden Führungsbereich auf. Man unterscheidet gerade und wendelförmig genutete Gewindebohrer, wobei sich letztere u. a. durch den Drallwinkel unterscheiden.

Oftmals werden derartige Gewindebohrer mit einer Titannitridbeschichtung (TiN) oder einer Titancarbonitridbeschichtung (TiCN) mittels PVD versehen. Bei derart, insbesondere mittels klassischem Magnetronzerstäuben beschichteten Gewindebohrern ist es häufig erforderlich, die Spanflächen nach dem Beschichten wieder blank zu schleifen. Eine der Ursachen hierfür kann darin liegen, dass aufgrund der Beschichtung die Gleit- und Reibeigenschaften nachteilig verändert werden woraus Spanformen resultieren können welche beim Gewindebohren Störungen verursachen.

Demgegenüber müssen Gewindebohrer, welche mittels thermischen Vakuumverdampfen mit TiN oder TiCN beschichtet werden nicht nachgeschliffen werden. Allerdings kann mit thermischem Verdampfen nur mit sehr grossem Aufwand die für ein wirtschaftliches Betreiben der Beschichtung erforderliche Stückzahl beschichtet werden.

Auch die Verwendung von Lichtbogenverdampfung (Arc-Verdampfung) für die Beschichtung der Gewindebohrer führt nicht zu den gewünschten Resultaten, vermutlich weil die mit dieser Art der Beschichtung einhergehenden sich in den Schichten einlagernden sogenannten Spritzer zu einer inakzeptablen Oberflächenrauheit führt. Auch hier würde daher ein Zeitaufwändiges und kostenintensives Schleifen nach der Beschichtung notwendig werden.

US2011/0220415 offenbart Schichten von CrN + TiN/DLC/Ti/DLC auf Bohrergestängen.

Der Erfindung liegt daher die Aufgabe zugrunde einen beschichteten Bohrer, insbesondere Gewindebohrer zu schaffen welcher nach der Beschichtung im Wesentlichen ohne das aufwändige Nachschleifen zum Einsatz kommen kann.

Hierbei ist ein Nachschleifen klar zu unterscheiden von einem relativ einfachen und günstigen, der Beschichtung nachfolgenden Bürstschritt, mit dem beispielsweise durch die Beschichtung entstandene Grate entfernt werden sollen.

Erfindungsgemäss wird die Aufgabe gelöst durch ein Verfahren nach Anspruch 9 Demzufolge wird auf einen Gewindebohrer mittels eines HIPIMS-Verfahren eine Hartstoffschicht aufgebracht. HIPIMS steht dabei für High Power Impuls Magnetron Sputtering und ist ein Zerstäubungsverfahren, bei dem grosse Entladestromdichten zu einem erhöhten ionisierungsgrad des zerstäubten Materials führen. Besonders bevorzugt sind erfindungsgemäss solche Schichten welche zumindest teilweise durch das in der DE102011018363 offenbarte Verfahren aufgebracht wurden. Bei diesem Verfahren wird ein sehr hoher Ionisierungsgrad des zerstäubten Materials erzielt. Die entsprechenden Ionen werden aufgrund eines an den Substraten angelegten negativen Bias zu diesen hin beschleunigt und führen zu einer sehr grossen Dichte. Da das in DE102011018363 beschriebene Verfahren, bei dem Spannungsquellen in Master-Slave Konfiguration betrieben werden zu einem sehr stabilen Beschichtungsprozess führen sind die damit entstehenden Schichten entsprechend kompakt, sehr gut haftend, homogen und mit einer geringen Oberflächenrauheit ausgestattet.

Besonders gute Ergebnisse werden erzielt wenn als HIPIMS-Schicht Schichten aus Nitriden und/oder Karbiden und/oder Oxiden die zumindest eines, vorzugsweise jedoch zwei der Metalle aus der Gruppe gebildet aus Chrom, Titan, Aluminium und Wolfram abgeschieden wurden. Dabei konnte sogar auf eine zwischen Bohrkörper und HIPIMS-Schicht angeordnete Haftschicht verzichtet werden. Dies ist vermutlich Folge der mit grosser Geschwindigkeit auf die Bohrkörper auftreffenden Ionen. Die Abscheidung der Nitride, Karbide oder Oxide kann dabei im Wechsel oder gleichzeitig erfolgen. Insbesondere die Erhöhung der Standzeiten von mit einer AlCrN HIPIMS-Schicht beschichteten Bohrern ist beeindruckend.

Gemäss der vorliegenden Erfindung ist auf der HIPIMS Schicht noch eine amorphe Kohlenstoff- oder DLC-Schicht vorgesehen, die insbesondere metallhaltig ausgeführt sein kann. Die amorphe-Kohlenstoff oder DLC-Schicht (im Folgenden Kohlenstoff enthaltende Schicht genannt) hat aufgrund ihrer guten Gleiteigenschaften den Vorzug einer geringeren Reibung an den Schnittkanten nicht entsprechenden Flächen, was zu einem geringeren Verschleiss und damit zu einer weiteren Verlängerung der Standzeiten der Gewindebohrer führt. Aufgrund der geringen Oberflächenrauheit der HIPIMS-Schicht weisst auch die darüber liegende Kohlenstoff enthaltende Schicht an der Oberfläche eine geringe Rauheit auf, insbesondere wenn darauf geachtet wird, dass die Kohlenstoff enthaltende Schicht eine Schichtdicke von 5µm nicht übersteigt. Das Gesamtschichtsystem hat vorzugsweise eine Dicke von 0.1µm bis 10µm.

Es wurde ein Verfahren zur Beschichtung eines Bohrers, vorzugsweise eines Gewindebohrers, offenbart mit Bohrkörper bei dem mittels eines HIPIMS-Verfahrens eine HIPIMS-Schicht aufgebracht wird, vorzugsweise direkt auf den Bohrkörper.

Vorzugsweise wird die Beschichtung mit einer Gesamtdicke von 0.1µm bis 10µm aufgebracht wird.

Vorzugsweise wird als HIPIMS-Schicht zumindest eine Schicht aus zumindest einem Nitrid und/oder Karbid und/oder Oxid mit zumindest einem, vorzugsweise jedoch zwei der Metalle aus der Gruppe gebildet aus Chrom, Titan, Aluminium und Wolfram abgeschieden.

Das Verfahren umfasst zumindest einen Beschichtungsschritt, bei dem eine DLC-Schicht, vorzugsweise eine metallhaltige DLC-Schicht auf die HIPIMS-Schicht aufgebracht wird.

Das metallische Element welches zur Beschichtung der metallhaltigen DLC-Schicht verwendet wird stimmt vorzugsweise mit einem metallischen Element in der HIPIMS-Schicht überein. Der Metallgehalt in der DLC Schicht kann zur Oberfläche hin gradientenhaft abnehmen.

Das oben erwähnten klassische Magnetronzerstäuben wird oft, wie auch im Rahmen der vorliegenden Beschreibung, konventioneller Sputterprozess oder konventionelles Sputtern genannt, alle diese Begriffe haben die gleiche Bedeutung. Von dem englischen Namen kommt auch die Abkürzung MS (magnetron sputtering), die auch die gleiche Bedeutung wie klassisches Magnetronzerstäuben hat und in dieser Beschreibung verwendet wird.

In ähnlicher Weise die oben erwähnten "in den Schichten eingelagerten sogenannten Spritzer", die durch die Verwendung von Lichtbogenverdampfungsprozessen (Arc-Verdampfungsprozessen) produziert werden, werden oft, wie auch im Rahmen der vorliegenden Beschreibung, Droplets oder Makropartikel genannt, die sehr charakteristisch von Arc-Schichten sind

Mit thermischen Vakuumverdampfen sind im Rahmen der vorliegenden Beschreibung plasmaunterstutzte Vakuumverdampfungsprozesse gemeint, bei denen eine Verdampfung des Schichtmaterials unter Verwendung einer Plasmaquelle zur thermischen Zufuhr unter Vakuumdruck stattfindet. Dafür kann beispielweise ein Niedervoltbogen als Plasmaquelle verwendet werden. Das zu verdampfende Schichtmaterial kann in einen Tiegel aufgestellt werden, der beispielweise als Anode eingeschaltet werden kann. Diese Beschichtungen haben sich aufgrund ihrer niedrigen Rauheit und im Allgemeinen gute Schichtqualität für die Beschichtung von Gewindebohrern gut etabliert. Allerdings sind die Prozessparameter nicht immer so einfach kontrollierbar.

Die Auswahl des Materials einer Beschichtung zur Leistungsverbesserung von Gewindebohrern ist nicht immer selbstverständlich. Zusätzlich spielt die Art des Beschichtungsprozesses auch eine grosse Rolle, da der Beschichtungsprozess direkt die Struktur der abgeschiedenen Schicht und damit ihre Eigenschaften beeinflusst.

Gewindebohrer mit einer TiCN-Beschichtung weisen beispielweise eine sehr hohe Oberflächenhärte auf und erweisen sich generell als widerstandsfähiger im Vergleich zu Gewindebohrern mit einer Beschichtung aus anderen Materialien. Hierdurch wird besonders der Kantengratbildung vorgebeugt.

Hingegen kann man mit eine TiN-Beschichtung nicht eine vergleichbare Oberflächenhärte erreichen, aber eine TiN-Beschichtung stellt im Allgemeinen eine gute Wahl zum Schutz von Bohrern dar, damit im Vergleich mit unbeschichteten Bohrern längere Standzeiten erzielt und höhere Geschwindigkeiten eingesetzt werden können.

Zum Bohren von nichtmetallischen Grundwerkstoffen, bei denen Bohrer mit Ti-basierenden Beschichtungen sich als nicht geeignet erwiesen, könnte in manchen Fällen eine mittels PVD abgeschiedene CrN-Beschichtung gut sein.

Beschichtete Gewindewerkzeuge erbringen höhere Standzeiten und erlauben eine deutliche Anhebung der Schnittdaten. Durch die Hartstoffbeschichtung erhöht sich die Verschleißfestigkeit des Gewindebohrers erheblich. Die Bildung von Kaltverschweißungen und Aufbauschneiden wird verhindert. Durch die stark reduzierte Reibung und das bessere Gleitverhalten der beschichteten Werkzeuge werden die Schnittkräfte herabgesetzt, der Verschleiss an den Schneidoberflächen verringert und die Oberflächengüte der geschnittenen Gewinde wesentlich verbessert.

Im spezifischen Fall von Gewindewerkzeugen am Beispiel von Gewindebohrern hat es sich in mehreren Versuchen erwiesen, dass mittels plasmaunterstutzten Vakuumverdampfens hergestellte Schichten (zukünftig Dampf-Schichten genannt) im Allgemeinen zu höheren Standzeiten im Vergleich mit mittels klassischen Magnetronzerstäuben oder mittels Lichtbogenverdampfen hergestellten Beschichtungen führenlm Rahmen der vorliegenden Erfindung wurden Gewindebohrer mit Arc-Schichten mit verschiedenen Zusammensetzungen und Schichtstrukturen beschichtet und ihre Zerspan-Leistung getestet. Gemäss den Ergebnissen waren fast alle getesteten Arc-Schichten im Vergleich mit den gut etablierten TiN- und TiCN-basierten Dampf-Schichten für diese Anwendung immer unterlegen. Sogar nach der Durführung von entsprechenden Nachbehandlungen zur Reduzierung der Oberflächenrauheit der Arc-Schichten. Jedoch, die Gewindebohrer mit Aluminiumchromnitrid-basierten Arc-Schichten (nach der Nachbehandlung) zeigten eine beinah ähnlich gleich gute Leistung wie die Gewindebohrer mit TiN- und TiCN-Dampf-Beschichtungen.

Dennoch, um äquivalenten Eigenschaften, vor allem in Bezug auf Dichte und Härte wie die AlCrN-basierten Arc-Schichten zu erreichen, aber mit einer besseren Oberflächenqualität um auswendigen Nachbehandlungen zu vermeiden, und demgemäss auch die Vorteile der plasmaunterstutzten Vakuumverdampfungs-Technologie irgendwie anzustreben, wurde die HIPIMS-Technologie für die Beschichtung der Gewindebohrer gemäss der vorliegenden Erfindung verwendet.

Gemäss der vorliegenden Erfindung kann eine vergleichbare oder sogar noch höhere Zerspanungsleistung im Vergleich zu den mittels plasmaunterstutzten Vakuumverdampfens hergestellten Schichten erreicht werden, wenn die Bohrer, am Beispiel von Gewindebohrer, mit zumindest eine HIPIMS-Schicht beschichtet werden, die vorzugsweise direkt auf dem Bohrerkörper aufgebracht wird.

Nach der Erfindung umfasst die die HIPIMS-Schicht zumindest eine Nitridschicht und/oder eine Karbidschicht .

Insbesondere, (Al,Cr)N HIPIMS-Schichten mit einer Konzentration von Aluminium in Bezug auf Chrom in Atomprozent von ca. 70 zu 30 zeigten sich als sehr gut geeignet zu erreichen vergleichbare Ergebnisse oder sogar bessere Ergebnisse (zumindest bei Gewindebohren von bestimmten Werkstückmaterialien) gegenüber die bisher gut etablierten (Ti,C)N Dampf-Schichten. Zusätzlich aufgrund der geringen Rauheit der HIPIMS-Schichten im Vergleich zu den ARC-Schichten kann man, wie schon oben erwähnt, auf die sonst notwendig teuren Nachbehandlungen verzichten oder viel günstigere und weniger aufwendige Nachbehandlungen verwenden.

Die oben erwähnte Schichtvariante gemäss der vorliegenden Erfindung, die eine DLC-Schicht oder vorzugsweise eine metallhaltige DLC-Schicht beinhaltet, die auf die HIPIMS-Schicht aufgebracht wird, lässt sich vorteilhafterweisemit der oben genannten Master-Slave Konfiguration herzustellen.

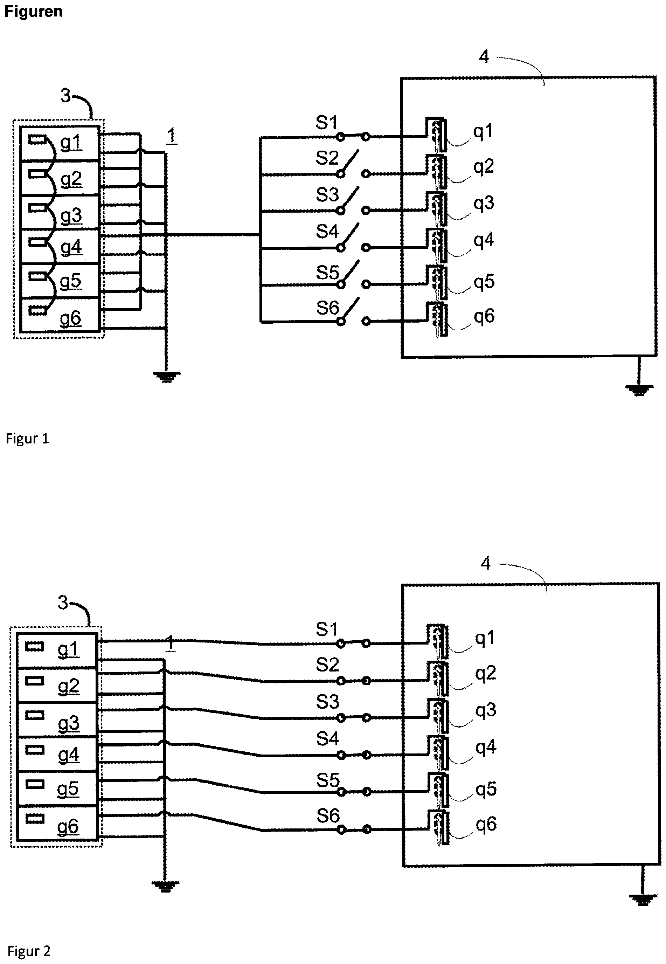

Die Master-Slave Konfiguration lässt sich anhand der Figuren 1 und 2 besser erklären.
Figur 1 zeigt eine Konfiguration mit elektrisch isolierten Targets q1, q2, q3, q4, q5 und q6, welche jeweils ein bewegtes Magnetsystem aufweisen, wobei die Leistungsversorgungseinheit aus mehreren Generatoren g1, g2, g3, g4, g5 und g6 besteht, die in Master-Slave Konfiguration verbunden sind.
Figur 2 zeigt eine Konfiguration mit elektrisch isolierten Targets q1, q2, q3, q4, q5 und q6, welche jeweils ein bewegtes Magnetsystem aufweisen, wobei die Leistungsversorgungseinheit aus mehreren Generatoren g1, g2, g3, g4, g5 und g6 besteht, die nicht in Master-Slave Konfiguration verbunden sind .

Um den Vorteil der Master-Slave Konfiguration zur Herstellung dieser Art von Schichten besser zu verstehen, wird im Folgenden beispielweise ein Prozess zur Beschichtung von Gewindebohrern mit einer Beschichtung bestehend aus 5 Schichten wie folgt beschrieben: 1) (Al,Cr)N, 2) CrN, 3) CrCN, 4) Cr-DLC und 5) DLC. Wobei:
1) die Funktionsschicht aus (Al,Cr)N mittels einem HIPIMS-Verfahren,
2) u. 3)die Zwischenschich aus CrN und die Zwischenschicht aus CrCN entweder mittels HIPIMS-Verfahren oder mittels konventionellem Sputtern (zukünftig auch bezeichnet als MS von dem englischen Namen Magnetron Sputtering) oder teilweise mittels HIPIMS-Verfahren und teilweise mittels MS,
4) die Gleitschicht aus Cr-dotiertem DLC mittels einer Kombination von MS- und PACVD-Verfahren (PACVD aus dem englischen Namen: Plasma Assisted Chemical Vapour Deposition treatment) oder mittels einer Kombination von HIPIMS- und PACVD-Verfahren oder teilweise mittels HIPIMS/PACVD-Verfahren und teilweise mittels MS/PACVD-Verfahren, und
5) die Einlaufschicht aus DLC mittels PACVD-Verfahren
   abgeschieden wird.

Vier AI-Targets und zwei Cr-Targets werden in die Beschichtungskammer (Vakuumkammer) elektrisch isoliert voneinander angeordnet und während des Beschichtungsprozesses durch eine Leistungsversorgungseinheit gespeist welche als Master-Slave Einheit konfiguriert ist. Man könnte aber auch Al/Cr-Targets verwendet mit einer bestimmten Zusammensetzung, um die gewünschte Schichtzusammensetzung zu erreichen. Solche Schichten können zum Beispiel schmelzmetallurgisch oder pulvermetallurgisch hergestellt werden.

Unter Master-Slave Konfiguration ist der parallele Zusammenschluss der Ausgänge zweier oder mehrerer Generatoren zu verstehen, wobei die einzustellende Leistung an einem der Generatoren (dem Master) gewählt wird und die anderen Generatoren elektronisch so verbunden sind, dass sie dem Master in ihren Einstellungen folgen. Vorzugsweise sind zumindest so viele Generatoren in Master-Slave Konfiguration zusammengeschaltet wie es einzelne elektrisch isolierte Targets gibt (siehe Figur 1 und 2).

Die Gewindebohrer werden zunächst gereinigt und/oder je nach Bedarf die zu beschichtende Oberfläche vorbehandelt. Anschliessend werden die Gewindebohrer in eine entsprechende Substrathalterung für die Beschichtung in die Vakuumkammer angeordnet. Nachdem Vakuum in die Vakuumkammer gezogen wird, werden die Gewindebohrer eines Heizungs- und eines Ätzprozesses unterzogen. Für die Abscheidung der HIPIMS (Al,Cr)N Schicht wird dann die Beschichtungskammer mit einer Gasmischung von Argon und Stickstoff überflutet. Die entsprechenden Gasflüsse werden so ausgewählt, dass das gewünschte Konzentrationsverhältnis von Argon zu Stickstoff sowie der gewünschte Gesamtdruck eingestellt werden. Um einen erhöhten Ionisationsgrad zu erreichen, wie er der von HIPIMS-Verfahren charakteristisch ist, wird die durch den Zusammenschluss resultierende erhöhte Leistung an die einzelnen Targets übertragen, aber nur so lange wie dies die Kühlung von jedem Target zulässt (um die Schmelzung oder Verbrennung des Targets zu vermeiden). Die Targets werden der Reihe nach zu und abgeschaltet. Die Leistungsversorgungseinheit in Master-Slave Konfiguration muss demnach nie gleichzeitig bei allen Teiltargets die volle Leistung erbringen (siehe Figur 1). Auf diese Weise können kostengünstigere Generatoren für die HIPIMS Abscheidung zum Einsatz kommen. Sobald die gewünschte Schichtdicke (Al,Cr)N Schicht erreicht wird, wird die CrN Zwischenschicht abgeschieden. Dafür wird die Master-Slave Konfiguration aufgelöst und somit wird für jedes Target ein eigener Generator zu Verfügung stehen (siehe Figur 2). Auf diese Weise wird erreicht, dass einfach und schnell von hochionisierendem Sputtern (HIPIMS) auf konventionelles Sputtern umgeschaltet wird und umgekehrt, wenn es gewünscht ist (mit Hilfe der Schalter S1, S2, S3, S4, S5, und S6, wie es beispielweise in den Figuren 1 und 2 gezeigt wird). Für die Abscheidung der CrN Zwischenschicht mittels konventionellem Sputtern werden dann nur die zwei Cr Targets eingeschaltet. In diesem Fall kann die Leistung an jedes Cr Target von jedem entsprechenden Generator ununterbrochen versorgt werden bis die gewünschte Dicke der CrN Zwischenschicht erreicht wird. Die Stickstoffkonzentration im Prozess sowie der gesamte Druck kann vor und/oder während der Abscheidung der CrN Schicht beliebig angepasst werden, um die gewünschten Schichteigenschaften zu erreichen. Für die Abscheidung der CrCN kann ein kohlenstoffhaltiges Reaktivgas in die Beschichtungskammer zugeführt werden, während die Flüsse der anderen Prozess- und Reaktivgassen angepasst werden. Auch hier kann die Konzentration der Prozess- und Reaktivgasen sowie die Leistung an den Cr-Targets vor und/oder während der Abscheidung der CrCN Schicht beliebig angepasst werden, um die gewünschten Schichteigenschaften zu erreichen. Vorzugsweise die Konzentration von Stickstoff und die Sputterleistung an den Cr-Targets wird reduziert bis die geeigneten Prozessbedingungen für die Abscheidung der Cr-DLC Schicht erreicht werden, und eine angemessene Bias-Spannung am Substrat für die Durchführung des PACVD-Verfahrens eingestellt wird. Nach dem auch die Cr-DLC Schicht die gewünschte Dicke erreicht hat wird die DLC abgeschieden. Für die Abscheidung der DLC-Einlaufschicht werden davor die Cr-Targets entweder abrupt oder graduell ausgeschaltet bis kein Cr mehr in die Schicht kommt und wenn nötig die Konzentration der Prozess- und Reaktivgassen sowie der Druck im Kammer und die Bias-Spannung am Substrat angepasst, um die gewünschten Schichteigenschaften zu erreichen.

Vorzugsweise wird bei der Abscheidung jeder Schicht eine angemessene Bias-Spannung am Substrat angelegt, die auch während der Abscheidung jeder Schicht beliebig angepasst werden kann.

Beschichtungen und Beschichtungsverfahren gemäss der vorliegenden Erfindung können insbesondere zur Erhöhung der Schneidleistung von Mikrobohrern von Vorteil sein, weil Schichten mit hoher Härte aber gleichzeitig gute Gleiteigenschaften und vor allem einer sehr geringen Rauheit vornehmlich für die Beschichtung von Mikrobohrern gefragt sind, um Ausbrüche an den Schneidkanten zu vermeiden. Ausserdem in dem Fall von Mikrobohrern ist die Durchführung von Nachbehandlungen zur Reduzierung der Schichtrauigkeit aufgrund der sehr geringen Dimensionen besonders auswendig, teuer und heikel, daher wäre es noch von Vorteil so eine Beschichtung gemäss der vorliegende Erfindung applizieren zu können, die vergleichbare Schneidleistung wie eine ARC-Schicht bringen kann aber mit der geringen Rauheit einer MS-Schicht. Weiterhin, sind die HIPIMS-Schichten gemäss der vorliegenden Erfindung im Vergleich zu ARC-Schichten viel besser geeignet für die Beschichtung von Mikrobohrer, weil die Abscheiderate dieser HIMPIMS-Schichten so gering sich einstellen lässt, dass beliebig sehr dünne Schichtdicken und mit grosser Genauigkeit (beispielweise Schichtdicken in Nanometerbereich) erreicht werden können, die aufgrund der sehr geringen Dimensionen der Mikrobohrer sehr von Vorteil sind.

Ein weiterer besonderer Vorteil der Verwendung von der Master-Slave HIPIMS Technologie ist die Möglichkeit beliebig und einfach die Pulslänge und die Pulsleistung während des Beschichtungsprozesses einzustellen, was die Abscheidung von HIPIMS-Schichten mit besonders erhöhten Qualität und je nach Anwendung beliebig angepassten Schichteigenschaften, beziehungsweise mit angepasster Schichtstruktur und/oder Schichtmorphologie ermöglicht.

## Patentansprüche

1. Bohrer, vorzugsweise Gewindebohrer oder Mikrobohrer, mit einer Beschichtung die zumindest am Bohrkopf des Bohrers bzw. gegebenenfalls am Anschnitt des Gewindebohrers ausgebildet ist und zumindest eine HIPIMS-Schicht aufweist welche vorzugsweise direkt auf dem Bohrkörper des Gewindebohrers aufgebracht ist, **dadurch gekennzeichnet, dass**
- die HIPIMS-Schicht zumindest eine Schicht aus zumindest einem Nitrid und/oder Karbid umfasst, und
- zumindest eine DLC-Schicht, vorzugsweise eine metallhaltige DLC-Schicht auf die HIPIMS-Schicht vorgesehen ist.

2. Bohrer nach Anspruch 1, **dadurch gekennzeichnet, dass** die HIPIMS-Schicht zumindest ein, vorzugsweise jedoch zwei der Metalle aus der Gruppe gebildet aus Chrom, Titan, Aluminium und Wolfram umfasst.

3. Bohrer nach Anspruch 2, **dadurch gekennzeichnet, dass** die HIPIMS-Schicht eine (Al,Cr)N-Schicht ist.

4. Bohrer nach Anspruch 3, **dadurch gekennzeichnet, dass** zumindest ein metallischen Element in der metallhaltige DLC-Schicht mit einem metallischen Element in der HIPIMS-Schicht übereinstimmt.

5. Bohrer nach Anspruch 4, **dadurch gekennzeichnet, dass** zwischen der HIPIMS-Schicht und die metallhaltige DLC-Schicht zumindest eine Stickstoff-Kohlenstoff-haltige Schicht abgeschieden ist, deren Stickstoffgehalt zur Oberfläche hin gradientenhaft abnimmt.

6. Bohrer nach einem der vorangehenden Ansprüche 3 bis 5, **dadurch gekennzeichnet, dass** der Metallgehalt in der DLC-Schicht zur Oberfläche hin gradientenhaft abnimmt.

7. Bohrer nach einem der vorangehenden Ansprüche 1 bis 6, **dadurch gekennzeichnet, dass** die Gesamtdicke der Beschichtung 0.1 µm bis 10 µm beträgt.

8. Bohrer nach einem der vorangehenden Ansprüche 1 bis 7, **dadurch gekennzeichnet, dass** der Bohrer ein Mikrobohrer ist und vorzugsweise die Gesamtdicke der Beschichtung 0.01 µm bis 5 µm beträgt.

9. Verfahren zur Herstellung eines Bohrers nach einem der vorangehenden Ansprüche 1 bis 8, bei dem
- die zumindest eine HIPIMS-Schicht mittels HIPIMS-Abscheidung aus metallhaltigen Targets in einer Atmosphäre welche Prozess- und Reaktivgasen umfasst, vorzugsweise direkt auf die zu beschichtenden Oberflächen des Bohrers, aufgebracht wird, und
- die zumindest eine DLC-Schicht mittels eines Beschichtungsverfahrens anderer Art, vorzugsweise mittels konventionellem Sputtern und/oder eines PACVD-Verfahrens und/oder eines kombinierten MS/PACVD-Verfahrens, auf die zumindest eine HIPIMS-Schicht aufgebracht wird.

10. Verfahren nach Anspruch 9, **dadurch gekennzeichnet, dass**
- die HIPIMS-Schicht dergestalt abgeschieden wird, dass sie auch ein Oxid umfasst, und/oder
- die DLC-Schicht als metallhaltiges DLC abgeschieden wird.

11. Verfahren nach einem der vorangehenden Ansprüche 9 bis 10, **dadurch gekennzeichnet, dass** die HIPIMS-Schicht aus Targets mit zumindest einem, vorzugsweise jedoch zwei der Metalle aus der Gruppe gebildet aus Chrom, Titan, Aluminium und Wolfram abgeschieden wird, vorzugsweise die HIPIMS-Schicht als (Al,Cr)N-Schicht oder (Al,Cr)N-haltige Schicht abgeschieden wird.

12. Verfahren nach einem der vorangehenden Ansprüche 10 bis 11, **dadurch gekennzeichnet, dass** für die Abscheidung der metallhaltigen DLC-Schicht ein kombiniertes Sputtern-PACVD-Verfahren verwendet wird, bei dem metall-haltige Targets in einer kohlenstoff-haltigen Atmosphäre gesputtert werden und eine für die Durchführung des PACVD-Verfahrens angemessene Bias-Spannung am zu beschichtenden Bohrer eingestellt wird, und vorzugsweise das Metall welches zur Abscheidung der metallhaltigen DLC-Schicht verwendet wird, mit einem Metall in der HIPIMS-Schicht übereinstimmt.

13. Verfahren nach einem der vorangehenden Ansprüche 10 bis 12, **dadurch gekennzeichnet, dass** die metallhaltige DLC-Schicht so abgeschieden wird dass der Metallgehalt in der DLC Schicht zur Oberfläche hin gradientenhaft abnimmt und vorzugsweise eine nicht-metallhaltige DLC-Einlaufschicht als Decklage auf dem metallhaltige DLC-Schicht aufgebracht wird.

14. Verfahren nach einem der vorangehenden Ansprüche, **dadurch gekennzeichnet, dass** die Pulslänge und die Pulsleistung während des HIPIMS-Prozesses eingestellt wird, um eine beliebige Schichtstruktur oder Schichtmorphologie zu produzieren.

15. Verfahren nach einem der vorangehenden Ansprüche 12 bis 14, **dadurch gekennzeichnet, dass**
- für die Abscheidung der HIPIMS-Schicht AlCr-Targets verwendet werden, um eine HIPIMS-Schicht aus (Al,Cr)N oder mit (Al,Cr)N zu produzieren, vorzugsweise mit einer Konzentration von Aluminium in Bezug auf Chrom von ca. 70 Al zu 30 Cr in Atomprozent, und
- für die Abscheidung der metall-haltigen DLC-Schicht Cr-Targets verwendet werden, um eine Chrom enthaltende DLC-Schicht zu produzieren, und
- zwischen der HIPIMS-Schicht und der metall-haltigen DLC-Schicht zumindest eine Zwischenschicht, vorzugsweise jedoch zumindest zwei Zwischenschichten abgeschieden werden, vorzugsweise die erste und/oder zweite Zwischenschicht aus CrN und/oder CrCN, und
- vorzugsweise eine nicht-metallhaltige DLC-Einlaufschicht als Decklage auf die metallhaltige DLC-Schicht aufgebracht wird

## Claims

1. Drill, preferably tap drill or micro drill, having a coating that is executed at least on the drill head of the drill or, if necessary, at the tip of the tap drill and that has at least one HIPIMS layer which is preferably applied directly onto the drill body of the tap drill, **characterized in that**
- the HIPIMS layer comprises at least one layer of at least one nitride and/or carbide, and
- at least one DLC layer, preferably a metalliferous DLC layer, is provided onto the HIPIMS layer.

2. Drill according to claim 1, **characterized in that** the HIPIMS layer comprises at least one, preferably however two of the metals from the group consisting of chromium, titanium, aluminum and tungsten.

3. Drill according to claim 2, **characterized in that** the HIPIMS layer is a (AI,Cr)N layer.

4. Drill according to claim 3, **characterized in that** at least one metallic element in the metalliferous DLC layer matches a metallic element in the HIPIMS layer.

5. Drill according to claim 4, **characterized in that** between the HIPIMS layer and the metalliferous DLC layer, at least one layer containing nitrogen and carbon is deposited, whose nitrogen content decreases gradually towards the surface.

6. Drill according to one of the preceding claims 3 to 5, **characterized in that** the metal content in the DLC layer decreases gradually towards the surface.

7. Drill according to one of the preceding claims 1 to 6, **characterized in that** the total thickness of the coating is between 0.1 µm and 10 µm.

8. Drill according to one of the preceding claims 1 to 7, **characterized in that** the drill is a micro drill and the total thickness of the coating is preferably between 0.01 µm and 5 µm.

9. Method for producing a drill according to one of the preceding claims 1 to 8 where
- the at least one HIPIMS layer is applied by means of a HIPIMS deposition of metalliferous targets in an atmosphere comprising process gases and reactive gases preferably directly onto the surfaces of the drill to be coated, and
- the at least one DLC layer is applied by means of a coating method of another type, preferably by means of conventional sputtering and/or a PACVD method and/or a combined MS/PACVD method onto the at least one HIPIMS layer.

10. Method according to claim 9 **characterized in that**
- the HIPIMS layer is deposited such that it comprises also an oxide and/or
- the DLC layer is deposited as metalliferous DLC.

11. Method according to one of the preceding claims 9 to 10, **characterized in that** the HIPIMS layer is deposited of targets with at least one, preferably however two of the metals from the group consisting of chromium, titanium, aluminum and tungsten, preferably the HIPIMS layer is deposited as a (AI,Cr)N layer or a layer containing (AI,Cr)N.

12. Method according to one of the preceding claims 10 to 11, **characterized in that** for depositing the metalliferous DLC layer a combined sputtering/PACVD method is used where metalliferous targets are sputtered in an atmosphere containing carbon and a bias voltage that is appropriate for executing the PACVD method is adjusted at the drill to be coated, and preferably the metal used for the deposition of the metalliferous DLC layer matches one metal in the HIPIMS layer.

13. Method according to one of the preceding claims 10 to 12, **characterized in that** the metalliferous DLC layer is deposited in such a way that the metal content in the DLC layer decreases gradually towards the surface and preferably a non-metalliferous DLC run-in layer is applied as top layer onto the metalliferous DLC layer.

14. Method according to one of the preceding claims, **characterized in that** the impulse length and the impulse power are set during the HIPIMS process to produce any desired layer structure or layer morphology.

15. Method according to one of the preceding claims 12 to 14, **characterized in that**
- AlCr targets are used for the deposition of the HIPIMS layer to produce a HIPIMS layer from (AI,Cr)N or with (AI,Cr)N, preferably with an aluminum concentration relative to the chromium in a ratio of approx. 70 Al to 30 Cr in atomic percent, and
- Cr targets are used for the deposition of the metalliferous DLC layer to produce a DLC layer containing chromium, and
- between the HIPIMS layer and the metalliferous DLC layer at least one interlayer, preferably however at least two interlayers are deposited, preferably the first and/or second interlayer from CrN and/or CrCN, and
- preferably a non-metalliferous DLC run-in layer is applied as top layer onto the metalliferous DLC layer.

## Revendications

1. Foret, de préférence taraud ou micro foret, avec un revêtement qui est formé sur au moins la tête de forage du foret, respectivement éventuellement sur l'entrée du taraud, et qui présente au moins une couche déposée par HiPIMS (pulvérisation cathodique magnétron en régime d'impulsions de haute puissance), laquelle est de préférence directement rapportée sur le corps de forage du taraud, **caractérisé en ce que**
- la couche par HiPIMS comprend au moins une couche constituée d'au moins un nitrure et/ou un carbure, et
- qu'au moins une couche de DLC (carbone semblable à du diamant), de préférence une couche de DLC contenant du métal, est prévue sur la couche par HiPIMS.

2. Foret selon la revendication 1, **caractérisé en ce que** la couche par HiPIMS comprend au moins un métal, de préférence pourtant deux des métaux du groupe constitué du chrome, du titane, de l'aluminium et du tungstène.

3. Foret selon la revendication 2, **caractérisé en ce que** la couche par HiPIMS est une couche de (AI,Cr)N.

4. Foret selon la revendication 3, **caractérisé en ce qu'**au moins un élément métallique dans la couche de DLC contenant du métal correspond avec un élément métallique dans la couche par HiPIMS.

5. Foret selon la revendication 4, **caractérisé en ce qu'**entre la couche par HiPIMS et la couche de DLC contenant du métal, au moins une couche contenant de l'azote et du carbone est déposée, dont la teneur en azote diminue selon un gradient jusqu'à la surface.

6. Foret selon l'une quelconque des revendications précédentes 3 à 5, caractérisé en ce la teneur en métal dans la couche de DLC diminue selon un gradient jusqu'à la surface.

7. Foret selon l'une quelconque des revendications précédentes 1 à 6, **caractérisé en ce que** l'épaisseur totale du revêtement se situe de 0,1 µm à 10 µm.

8. Foret selon l'une quelconque des revendications précédentes 1 à 7, **caractérisé en ce que** le foret est un micro foret et que de préférence l'épaisseur totale du revêtement se situe de 0,01 µm à 5 µm.

9. Procédé de fabrication d'un foret selon l'une quelconque des revendications précédentes 1 à 8, dans lequel
- l'au moins une couche par HiPIMS est rapportée de préférence directement sur les surfaces du foret à être revêtues au moyen d'un dépôt par HiPIMS de cibles contenant du métal, dans une atmosphère comprenant des gaz de procédé et de réaction, et
- l'au moins une couche de DLC est rapportée sur l'au moins une couche par HiPIMS au moyen d'un procédé de revêtement d'un autre type, de préférence au moyen d'une pulvérisation cathodique conventionnelle et/ou d'un procédé PACVD et/ou d'un procédé combiné MS/PACVD (pulvérisation magnétron asymétrique/dépôt chimique en phase vapeur assisté par plasma).

10. Procédé selon la revendication 9, **caractérisé en ce que**
- la couche par HiPIMS est déposée de telle manière qu'elle comprend également un oxyde, et/ou
- la couche de DLC est déposée sous la forme de DLC contenant du métal.

11. Procédé selon l'une quelconque des revendications précédentes 9 à 10, **caractérisé en ce que** la couche par HiPIMS est déposée à partir de cibles avec au moins un, de préférence pourtant deux des métaux du groupe constitué du chrome, du titane, de l'aluminium et du tungstène, de préférence que la couche par HiPIMS est déposée sous la forme d'une couche de (AI,Cr)N ou d'une couche contenant du (AI,Cr)N.

12. Procédé selon l'une quelconque des revendications précédentes 10 à 11, **caractérisé en ce que**, pour le dépôt de la couche de DLC contenant du métal, un procédé combiné de pulvérisation cathodique et de PACVD est employé, dans lequel des cibles contenant du métal sont pulvérisées dans une atmosphère contenant du carbone et que, pour la réalisation du procédé PACVD, une tension de polarisation appropriée est réglée au niveau du foret à être revêtu, et que, de préférence le métal, lequel est employé pour le dépôt de la couche de DLC contenant du métal, correspond avec un métal dans la couche par HiPIMS.

13. Procédé selon l'une quelconque des revendications précédentes 10 à 12, **caractérisé en ce que** la couche de DLC contenant du métal est déposée de telle manière que la teneur en métal dans la couche de DLC diminue selon un gradient jusqu'à la surface et de préférence qu'une couche de rodage de DLC ne contenant pas de métal est rapportée sur la couche de DLC contenant du métal servant de couche de couverture.

14. Procédé selon l'une quelconque des revendications précédentes, **caractérisé en ce que** la longueur d'impulsion et la puissance d'impulsion pendant le procédé HiPIMS sont réglées afin de produire une structure de couche ou une morphologie de couche variables à souhait.

15. Procédé selon l'une quelconque des revendications précédentes 12 à 14, **caractérisé en ce que**
- pour le dépôt de la couche par HiPIMS, des cibles à base d'AlCr sont employées, afin de produire une couche par HiPIMS à base de (AI,Cr)N ou avec de l'(Al,Cr)N, de préférence avec une concentration en aluminium par rapport au chrome d'environ 70 Al pour 30 Cr en pourcentage d'atomes, et
- pour le dépôt de la couche de DLC contenant du métal, des cibles à base de Cr sont employées, afin de produire une couche de DLC contenant du chrome, et
- qu'entre la couche par HiPIMS et la couche de DLC contenant du métal, au moins une couche intermédiaire, de préférence pourtant deux couches intermédiaires, est/sont déposée/s, de préférence la première et/ou la deuxième couche(s) intermédiaire(s) constituée(s) de CrN et/ou de CrCN, et
- de préférence une couche de rodage de DLC ne contenant pas de métal est rapportée sur la couche de DLC contenant du métal servant de couche de couverture.
